Europäisches Patentamt

European Patent Office

Office européen des brevets

(11) Publication number: **0 412 741 A2**

# EUROPEAN PATENT APPLICATION

(21) Application number: 90308607.2

(22) Date of filing: 06.08.90

(51) Int. Cl.⁵: **H01L 21/58**, H01L 23/482

(30) Priority: 08.08.89 JP 206185/89

(43) Date of publication of application:
13.02.91 Bulletin 91/07

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Sakata, Yujiro c/o NEC Kyushu Ltd.**
**100, Yahatamachi Kumamoto-shi**
**Kumamoto(JP)**

(74) Representative: **Pritchard, Colin Hubert et al**
**Mathys & Squire 10 Fleet Street**
**London EC4Y 1AY(GB)**

(54) Conductive adhesive sheet used in semiconductor device manufacture.

(57) A adhesive sheet is used as a wafer sheet for retaining a semiconductor wafer while grinding or separating into semiconductor chips, and the adhesive sheet comprises a flexible film structure (1) having a conductibility and an adhesive layer (2) coated on one surface of said flexible film structure, wherein the conductive flexible film structure prevents an integrated circuit produced in each semiconductor chip from damages due to static electricity produced between the adhesive sheet and the semiconductor wafer or chips upon peeling off.

FIG. 1

## CONDUCTIVE ADHESIVE SHEET USED IN SEMICONDUCTOR DEVICE MANUFACTURE

### FIELD OF THE INVENTION

This invention relates to an adhesive sheet used in the semiconductor device manufacture and, more particularly, to a wafer sheet for retaining semiconductor chips in an assembly and packing stage of the semiconductor device manufacture.

### DESCRIPTION OF THE RELATED ART

When an integrated circuit is patterned in individual small areas of a semiconductor wafer, the semiconductor wafer is separated into a large number of semiconductor chips, and each of the semiconductor chips is, by way of example, assembled in a package. A wafer sheet is usually used in the separation and prevents the semiconductor chips from being scattered and lost. In a standard process, a semiconductor wafer is scribed to form lattice-shaped shallow scratches, and a wafer sheet is adhered to the semiconductor wafer. Even if the semiconductor wafer is broken into a large number of semiconductor chips, the wafer sheet retains the semiconductor chips, and the small semiconductor chips proceed to the subsequent stage without any loss. Each of the semiconductor chips is peeled off in the subsequent stage. The prior art wafer sheet thus used is formed of a resin or polymer film such as polyethylene, polyvinyl chloride or polyvinylidene chloride. The polyethylene and the polyvinyl chloride are not less than $10^{16}$ ohm-cm, and the polyvinylidene chloride ranges from $10^{14}$ ohm-cm to $10^{16}$ ohm-cm. The resin films are of the insulator, and a problem is encountered in the prior art wafer sheet in that an integrated circuit produced in the semiconductor chip is liable to be destroyed due to static electricity produced upon peeling off. The insulating wafer sheet allows the static electricity to attack the semiconductor chip.

Since the insulating wafer sheet accumulates the static electricity, a dust is attracted to the wafer sheet and, accordingly, the semiconductor chip, and the dust is causative of an inferior semiconductor device. The inferior semiconductor device deteriorates the production yield and, accordingly, increases the production cost.

### SUMMARY OF THE INVENTION

It is therefore an important object of the present invention to provide an adhesive sheet which prevents semiconductor chips from the destruction.

It is also an important object of the present invention to provide an adhesive sheet which is conducive to enhancement of the production yield of a semiconductor device.

To accomplish these objects, the present invention proposes to impart conductibility to an adhesive sheet.

In accordance with the present invention, there is provided an adhesive sheet used in manufacturing a semiconductor device, comprising: a) a flexible film structure having a conductibility; and b) an adhesive layer coated on one surface of the flexible film structure.

### BRIEF DESCRIPTION OF THE DRAWINGS

The features and advantages of an adhesive sheet according to the present invention will be more clearly understood from the following description taken in conjunction with the accompanying drawings in which:

Fig. 1 is a cross sectional view showing an adhesive sheet according to the present invention;

Fig. 2 is a cross sectional view showing another adhesive sheet according to the present invention;

Fig. 3 is a cross sectional view showing still another adhesive sheet according to the present invention;

Fig. 4 is a perspective view showing a wafer sheet adhered to semiconductor wafers;

Figs. 5A is a cross sectional view showing a grinding operation on a semiconductor wafer retained by the wafer sheet;

Fig. 5B is a perspective view showing a peeling-off stage after the grinding operation; and

Figs. 6A to 6C are perspective views showing a sequence of separating operation on a semiconductor wafer retained by the wafer sheet.

### DESCRIPTION OF THE PREFERRED EMBODIMENTS

First Embodiment

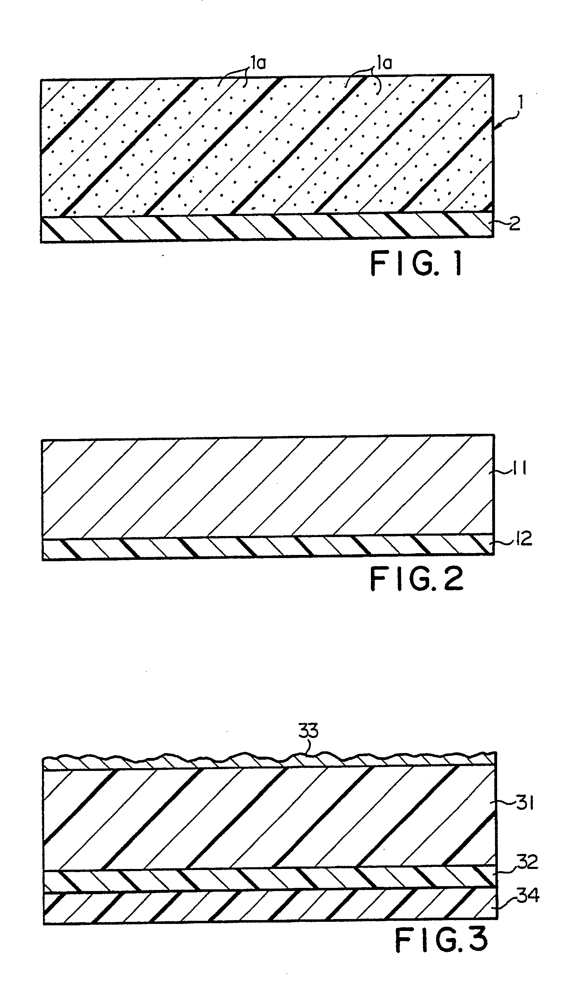

Referring first to Fig. 1 of the drawings, an adhesive sheet embodying the present invention comprises a flexible resin film 1 containing a conductive substance 1a. A carbon-containing polyethylene is available for the flexible resin film 1 by way of example. If a polyethylene film, a polyvinyl chloride film and a polyvinylidene chloride film contain ethoxyl tertiary amine, the films have conductibility and are, therefore, available for the flexible resin film 1. The carbon may be contained in the form of particles 1a. The flexible resin film 1 ranges from $10^8$ ohm-cm to $10^{12}$ ohm-cm. An adhesive layer 2 is coated on one surface of the flexible resin film 1, and the adhesive layer 2 may be formed of a paste of an organic compound. However, such an adhesive organic compound is well known to a person skilled in the art, and, for this reason, no further description is incorporated hereinbelow. The adhesive layer 2 is brought into contact with a semiconductor wafer and allows semiconductor chips to be retained on the flexible resin film 1.

Second Embodiment

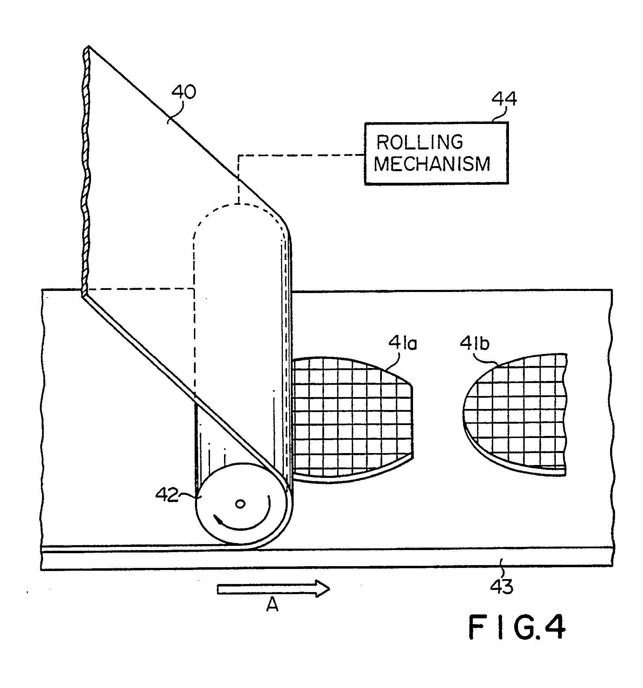

Turning to Fig. 2 of the drawings, another adhesive sheet embodying the present invention comprises a flexible film 11 coated with an adhesive layer 12. The flexible film 11 is formed of a polymer of a conductive organic compound such as, for example, an organic phosphate or an organic compound the composition of which contains chlorine. The conductive organic compound also ranges from $10^8$ ohm-cm to $10^{12}$ ohm-cm.

Third Embodiment

Turning to Fig. 3 of the drawings, still another adhesive sheet embodying the present invention comprises a flexible film 31 of polyvinyl chloride or polyethylene coated with an adhesive layer 32, a conductive film 33 and a separator 34 formed of a polyvinyl chloride film or a polyethylene film. The separator 34 is removed from the adhesive layer 32, and adhesive layer 32 is, then, adhered to a semiconductor wafer. In this instance, the conductive film 33 discharges undesirable static electricity.

Practical Usage

Any of the adhesive sheets shown in Figs. 1 to 3 is used as a wafer sheet 40 while manufacturing a semiconductor device. The wafer sheet 40 is adhered to semiconductor wafers 41a and 41b with a roller 42 as shown in Fig. 4. Namely, the semiconductor wafers 41a and 41b are mounted on a table 43, and the wafer sheet 40 is guided by the roller 42. The roller 42 associated with a rolling mechanism 44 is driven for rotation and proceeds in a direction indicated by arrow A. When the roller 42 rolls on in the direction indicated by arrow A, the wafer sheet 40 is gradually unwound from a roll (not shown) and adhered to the semiconductor wafers 41a and 41b.

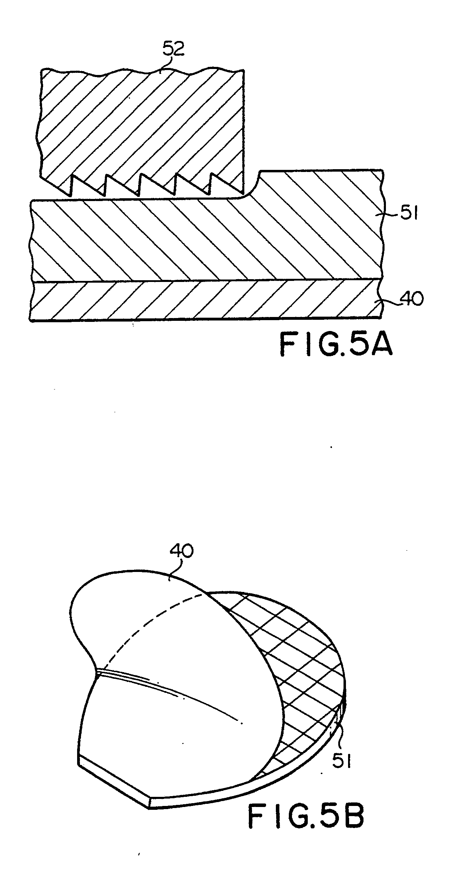

The wafer sheet 40 is useful in a grinding stage. Namely, the wafer sheet 40 is adhered to a front surface of a semiconductor wafer 51, and the back surface of the semiconductor wafer 51 is grinded with a tool 52 as shown in Fig. 5A. Upon completion of the grinding operation on the back surface of the semiconductor wafer 51, the wafer sheet 40 is peeled off as shown in Fig. 5B. However, the integrated circuits fabricated on the individual semiconductor chips are hardly damaged due to the static electricity, because the conductive wafer sheet 40 rapidly discharges the undesirable static electricity.

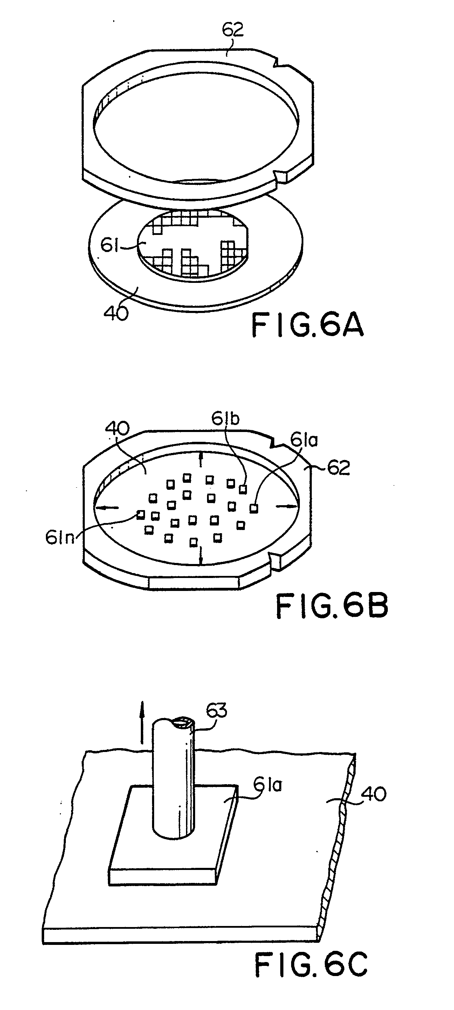

The wafer sheet 40 is further useful in a separation stage. In the separation stage, lattice-shaped scratches are formed in a semiconductor wafer 61, and the semiconductor wafer 61 is, then, separated into a large number of semiconductor chips. The semiconductor wafer 61 or the component semiconductor chips are retained by the wafer sheet 40 through the rolling stage shown in Fig. 4, and a jig member 62 is brought into contact with the wafer sheet 40 so that the semiconductor wafer 40 or the component semiconductor chips are located inside of the jig member 62 as shown in Fig. 6A. The outer periphery of the wafer sheet 40 is radially pulled, and, accordingly, the wafer sheet 40 is outwardly elongated as shown in Fig. 6B. When the wafer sheet 40 is outwardly elongated, the semiconductor chips 61a, 61b, ... and 61n are spaced apart from one another, and a vacuum pincette 63 sequentially absorbs one of the semiconductor chips 61a to 61n. The vacuum pincette 63 upwardly lifts one of the semiconductor chips 61a to 61n to be absorbed and conveys it to a suitable place for the subsequent stage. When the vacuum pincette 63 lifts the semiconductor chip such as the chip 61a, undesirable static electricity is procured. However, the conductive wafer sheet 40 allows the static electricity to be rapidly discharged, and, for this reason, the integrated circuit fabricated on the semiconductor chip 61a is hardly damaged. This results in improvement of the production yield and, accordingly, the production cost.

As will be understood from the foregoing description, the adhesive sheet according to the present invention is conductive, and, for this reason, an integrated circuit fabricated on a semiconductor chip is hardly attacked by undesirable static electricity. The conductive adhesive sheet further prevents the semiconductor chips from a dust. This results in that an inferior semiconductor chip hardly takes place in the grinding stage and the separation stage, and the production yield and the production cost are improved by using the adhesive sheet according to the present invention.

Although particular embodiments of the present invention have been shown and described, it will be obvious to those skilled in the art that various changes and modifications may be made without departing from the spirit and scope of the present invention. The adhesive sheet according to the present invention is available in any stage which hates static electricity.

## Claims

1. An adhesive sheet used in manufacturing a semiconductor device. comprising: a) a flexible film structure (1; 11; and 31/33); and b) an adhesive layer (2; 12; and 32) coated on one surface of said flexible film structure, characterised in that said flexible film structure has a conductibility.

2. An adhesive sheet as claimed in claim 1, wherein the said flexible film structure has a resistivity of $10^8$ to $10^{12}$ ohm cms.

3. An adhesive sheet as claimed in claim 1 or 2, wherein the said flexible film structure comprises a film of polyethylene, polyvinyl chloride, or polyvinylidene, the said film containing ethoxyl tertiary amine.

4. An adhesive sheet as claimed in claim 1 or 2, wherein the said flexible film structure comprises a film of polyethylene containing carbon particles.

5. An adhesive sheet as claimed in claim 1 or 2, wherein the said flexible film structure comprises a film of a conductive organic compound.

6. An adhesive sheet as claimed in claim 5, wherein the said organic compound is an organic phosphate or an organic compound containing chlorine.

7. An adhesive sheet as olaimed in claim 1, wherein the said flexible film structure comprises a film of polyethylene or polyvinyl chloride, and a conductive film which is located on a surface of the flexible film structure opposite to the surface on which the adhesive layer is coated.

EP 0 412 741 A2

FIG. 1

FIG. 2

FIG. 3

FIG.4

52

51

40

FIG.5A

40

51

FIG.5B

FIG.6A

FIG.6B

FIG.6C